(19)

Europäisches Patentamt
European Patent Office
Office européen des brevets

(11)   EP 2 952 922 B1

(12)                           **EUROPEAN PATENT SPECIFICATION**

(45) Date of publication and mention
of the grant of the patent:
**10.07.2019  Bulletin 2019/28**

(51) Int Cl.:
***G01R 31/36*** *(2019.01)*

(21) Application number: **15173421.7**

(22) Date of filing: **17.04.2014**

(54) **BATTERY MANAGEMENT SYSTEM AND DRIVING METHOD THEREOF**

BATTERIEVERWALTUNGSSYSTEM UND ANTRIEBSVERFAHREN DAFÜR

SYSTÈME DE GESTION DE BATTERIE ET SON PROCÉDÉ DE COMMANDE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.04.2013  KR 20130043023**

(43) Date of publication of application:
**09.12.2015  Bulletin 2015/50**

(62) Document number(s) of the earlier application(s) in
accordance with Art. 76 EPC:
**14165260.2 / 2 793 038**

(73) Proprietor: **Samsung SDI Co., Ltd.
Yongin-si, Gyeonggi-do (KR)**

(72) Inventors:
• **CHO, Young-Shin
  Gyeonggi-do (KR)**
• **LEE, Soo-Jin
  Gyeonggi-do (KR)**
• **SHIM, Young-Woo
  Gyeonggi-do (KR)**

(74) Representative: **Taor, Simon Edward William
Venner Shipley LLP
200 Aldersgate
London EC1A 4HD (GB)**

(56) References cited:
**EP-A1- 2 071 345          FR-A1- 2 934 374
US-A1- 2004 128 089    US-A1- 2008 255 783
US-A1- 2012 029 851**

## Description

The disclosed technology generally relates to a battery management system and a method of using the same. More particularly, the disclosed technology relates to a battery management system for managing the capacity of a battery.

Due to a growing demand, technologies relating to high-power and high-energy secondary batteries using non-aqueous electrolytes have advanced tremendously. In order to form a high-capacity secondary battery module, a plurality of high-power secondary battery cells can be connected in series or in parallel. The modules can in turn be assembled into a high-capacity battery pack. A battery cell is the smallest unit that can be integrated into a battery module, which typically includes several battery cells. A battery pack in turn typically includes several battery modules. While the battery management system disclosed herein can be applied at any level of integration, for simplicity, an integrated unit of battery cells is simply referred to hereinafter as a "battery."

In order to maximize the efficient use of a battery, a battery management system (BMS) is often employed to estimate various capacities of the battery through monitoring battery parameters such as the voltage, the current, and the temperature at a given discharge condition of the battery. In order to accurately estimate one capacity value, other capacity values also need to be accurately estimated. For example, the accuracy of estimation of the remaining capacity of the battery depends on the accuracy of estimation of other capacities of the battery, such as the theoretical maximum capacity and the unusable capacity, among others. While many BMS are equipped to estimate these capacities using fixed correlations such as the open circuit voltage versus the state of charge, they do not take into account of the changing nature (e.g., during a charge/discharge cycle or through degradation) of various characteristics of the battery. For example, parameters such as the internal resistance of the battery not only change as a function of depth of discharge, but also as a function of battery degradation. Thus, there is a need for a BMS capable of accurately estimating various capacities of the battery that takes into account of the changing characteristics.

EP2071345 discloses comparing a measured voltage at terminals of a battery of a motor vehicle based on a time with a group of voltage curves based on the time to determine target voltage curves that are the voltage curves of the group nearer to the measured voltage. An internal resistance value corresponding to a voltage to current transformation function having a target curve voltage or an average function of internal resistance values corresponding to transformation functions having target curve voltages, is chosen as another internal resistance value (R) of the battery.

According to an aspect of the invention, there is provided a driving method of a battery management system as set out in claim 2. Preferred features are set out in claims 3 to 5.

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey the scope of the example embodiments to those skilled in the art.

In the drawing figures, dimensions may be exaggerated for clarity of illustration. It will be understood that when an element is referred to as being "between" two elements, it can be the only element between the two elements, or one or more intervening elements may also be present. Like reference numerals refer to like elements throughout.

The MCU may further include a used capacity calculating unit that calculates a used capacity of the battery, using an open circuit voltage (OCV) that is a voltage value measured at the time when the battery is stabilized.

The MCU may further include a current integration unit that calculates an integrated current value obtained by integrating the current value. The integrated current value at the calculation time of the used capacity may be zero.

The MCU may further include an uncharged capacity calculating unit that calculates the uncharged capacity, using the used capacity and a first integrated current value obtained by integrating the current value from the calculation time of the used capacity to the full-charge time of the battery.

The full-charge time may mean a time when the magnitude of the obtained voltage value is no less than a predetermined full-charge voltage value and when the magnitude of the obtained current value is less than a predetermined value.

The MCU may further include a maximum capacity calculating unit that calculates the maximum capacity of the battery, using a first depth of discharge (DoD) calculated using a first OCV that is a voltage value obtained at a first stabilized time just before the last charge or discharge of the battery, a second DoD calculated using a second OCV that is a voltage value obtained at a second stabilized time after the last charge or discharge of the battery, and a second integrated current value obtained by integrating the current value from the calculation time of the used capacity to the second stabilized time.

The stabilized time may mean a time to satisfy at least one of a case where the magnitude of the current value discharged in the battery during a predetermined time is less than a predetermined value and a case where the change in the magnitude of the voltage value is less than a predetermined value.

The maximum capacity calculating unit may calculate the maximum capacity when the second integrated current value is no less than a predetermined value.

The MCU may further include a remaining capacity calculating unit that calculates an actually usable remaining capacity of the battery, using the total usable capacity, the uncharged capacity, the used capacity and a third integrated current obtained by integrating the current value from the calculation time of the used capacity to the current time.

The internal resistance may be calculated using a reference internal resistance and a temperature value under the discharge condition and a temperature correction value. The reference internal resistance may mean a resistance calculated, using at least one of an OCV estimated using an SOC at an arbitrary point, current, voltage and temperature value, measured at the arbitrary point, and the temperature correction value, and the temperature correction variable means a relation data between temperature and internal resistance for standardizing internal resistance values.

According to another aspect of the present invention, there is provided a battery management system as set out in claim 1.

The driving method may further include calculating a unusable capacity unusable under a current discharge condition of the battery, using the current value and the internal resistance of the battery.

The driving method may further include calculating a total usable capacity of the battery, using a maximum capacity of the battery, the uncharged capacity of the battery and the unusable capacity.

The driving method may further include calculating an actually usable remaining capacity of the battery, using the total usable capacity, the uncharged capacity, the used capacity and an integrated current obtained by integrating the current value from the calculation time of the used capacity to the current time.

According to various aspects, it is possible to efficiently calculate the capacity of a battery in consideration of a current discharge condition.

According to an aspect of the invention, there is provided a battery management system, comprising: a sensing unit configured to measure a current value and a voltage value of a battery under a discharge condition of the battery; and a main controller unit, MCU, configured to receive the current and voltage values and further configured to manage capacities of the battery based at least in part on the current and voltage values, wherein the MCU includes an unusable capacity calculating unit configured to calculate an unusable capacity corresponding to a portion of a theoretical maximum capacity of the battery that is unusable under the discharge condition, wherein the unusable capacity is calculated based at least in part on the current value and an internal resistance value of the battery under the discharge condition.

In some embodiments, the unusable capacity includes a portion of the theoretical maximum capacity that remains in the battery when the magnitude of the voltage value has reached a discharge stop voltage corresponding to a minimum voltage that is sufficient to drive a device connected to the battery.

In some embodiments, sensing unit is further configured to measure a temperature value of the battery under the discharge condition.

In some embodiments, the unusable capacity calculating unit is configured to calculate the unusable capacity further based on a previously stored current data in the MCU and a proportionality coefficient between the internal resistance and the unusable capacity; optionally wherein the unusable capacity calculating unit is further configured to make a correcting adjustment to the internal resistance of the battery based on a correction variable determined according to the magnitude of the current value.

In some embodiments, the MCU further includes a total usable capacity calculating unit configured to calculate a total usable capacity of the battery at least in part based on the theoretical maximum capacity of the battery, an uncharged capacity of the battery, and the unusable capacity.

In some embodiments, the MCU further includes a used capacity calculating unit configured to calculate a used capacity of the battery at least in part based on an open circuit voltage (OCV) value measured at a time when the battery has been stabilized, wherein the time when the battery has been stabilized corresponds to a discharge condition satisfying at least one of the conditions of the current value during a predetermined time being less than a predetermined current value and a change in the voltage value being less than a predetermined voltage value.

In some embodiments, the MCU further includes a current integration unit configured to calculate an integrated current value by integrating the current value at least in part by setting as zero the integrated current value at a time when the used capacity is calculated.

In some embodiments, the MCU further includes an uncharged capacity calculating unit configured to calculate the uncharged capacity based at least in part on the used capacity and a first integrated current value obtained by integrating the current value from the calculation time of the used capacity to a full-charge time of the battery, wherein the full-charge time corresponds to a discharge condition when the voltage value is greater than or equal to a predetermined full-charge voltage value and when the current value is less than a predetermined full-charge current value.

In some embodiments, the MCU further includes a maximum capacity calculating unit configured to calculate the theoretical maximum capacity of the battery based at least in part on a first depth of discharge, DoD, calculated based on a first OCV value obtained at a first stabilized time prior to a last charge or prior to a last discharge of the battery, a second DoD calculated based on a second OCV value obtained at a second stabilized time after the last charge or after the last discharge of the battery, and a second integrated current value obtained by integrating the current value from the calculation time of the used capacity to the second stabilized time; optionally wherein the maximum capacitating unit is configured to calculate the theoretical maximum capacity when the second integrated current value is greater than or equal to a predetermined value.

In some embodiments, the MCU further includes a remaining capacity calculating unit configured to calculate a remaining capacity that is available for use, using the total usable capacity, the uncharged capacity, the used capacity and a third integrated current value obtained by integrating the current value from the calculation time of the used capacity to a time when the remaining capacity is calculated.

In some embodiments, the battery management system is further configured to calculate the internal resistance based on a reference internal resistance, and a temperature correction value, wherein the reference internal resistance is calculated based at least on one of an open circuit voltage, OCV, value estimated using a state of charge, SOC, value, a current value, a voltage value, and the temperature correction value, wherein the temperature correction variable is determined based on a relationship between the temperature value and the internal resistance.

According to an aspect of the invention, there is provided a battery management system as set out in claim 1.

According to an aspect of the invention, there is provided a driving method of a battery management system as set out in claim 2. Preferred features are set out in claims 2 to 5.

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey the scope of the example embodiments to those skilled in the art.

In the drawing figures, dimensions may be exaggerated for clarity of illustration. It will be understood that when an element is referred to as being "between" two elements, it can be the only element between the two elements, or one or more intervening elements may also be present. Like reference numerals refer to like elements throughout.

FIG. 1 is a view three-dimensional view of a battery according to an embodiment.

FIG. 2 is a block diagram schematically illustrating a battery management system (BMS) according to an embodiment.

FIG. 3 is a graph illustrating the relationship between open circuit voltage (OCV) and state of charge (SOC) according to an embodiment.

FIG. 4 is a graph illustrating the relationship among unusable capacity, current, temperature and internal resistance according to an embodiment.

FIG. 5 is a graph illustrating the relationship between internal resistance and depth of discharge (DoD) of a battery according to an.

FIG. 6 is a graph illustrating the relationship among maximum capacity, total usable capacity, uncharged capacity, used capacity, unusable capacity and remaining capacity of a battery according to an embodiment.

FIG. 7 is a flowchart illustrating a driving method of the BMS according to an embodiment.

Hereinafter, certain exemplary embodiments according to the present invention will be described with reference to the accompanying drawings. Here, when a first element is described as being coupled to a second element, the first element may be not only directly coupled to the second element but may also be indirectly coupled to the second element via a third element. Further, some of the elements that are not essential to the complete understanding of the invention are omitted for clarity. Also, like reference numerals refer to like elements throughout.

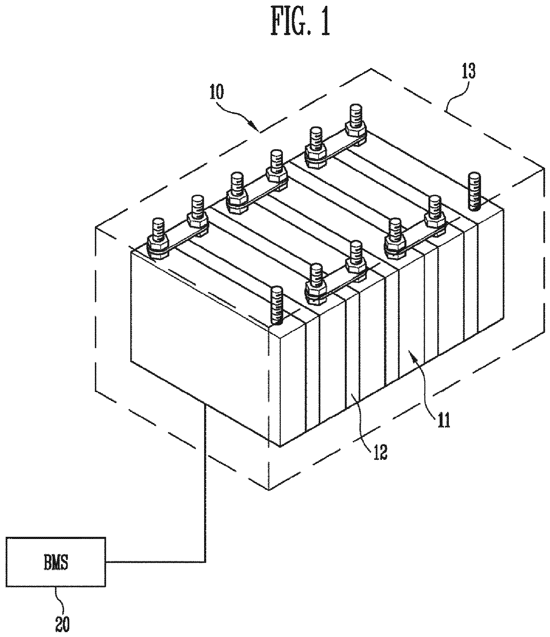

FIG. 1 is a view illustrating a battery according to an embodiment.

Referring to FIG. 1, the battery 10 as a large-capacity battery module includes a plurality of secondary batteries 11 consecutively arranged at a predetermined interval; a housing 13 accommodating the plurality of secondary batteries 11 therein and having a cooling medium moved therein; and a battery management system 20 managing charge/discharge of the battery 10.

Battery partition walls 12 may be respectively arranged between the secondary batteries and at the outermost secondary batteries 11. The battery partition wall 12 performs a function of allowing air for temperature control to be moved while constantly maintaining the interval between the secondary batteries 11, and supporting side surfaces of each secondary battery 11.

Although it has been illustrated in FIG. 1 that the secondary batteries 11 has a quadrangular structure, it will be apparent that the secondary batteries 11 may have a cylindrical structure.

The BMS 20 receives data from a current sensor, a voltage sensor and a temperature sensor, which are mounted in the battery 10, and manages the capacity of the battery 10, using the data.

Some methods of calculating the capacity of a general battery 10 simultaneously use integrated current using discharge efficiency of the battery 10 and capacity correction using voltage at the last stage of discharge. For example, in case of the full-charged battery 10, the capacity of the battery is calculated using a discharge efficiency table and an integrated current value at the initial and middle stages of discharge, and the calculated capacity is corrected using the voltage of the battery 10 at the last stage of discharge.

However, the method has three problems as follows. A first problem is that parameters (in a discharge efficiency table and a voltage correction table) used to calculate the capacity of the battery 10 are used as fixed values. However, characteristics of the battery 10 are changed as the degradation of the battery 10 is advanced, and therefore, the accuracy of the method is decreased as time elapses.

A second problem results from calculation of self-discharge. The self-discharge is a phenomenon that the battery 10 is naturally discharged during a period in which the battery 10 is not used. The capacity of the battery 10 discharged described above cannot be measured through current measurement, and hence the method reflects an arbitrarily fixed value as time elapses. However, there is a problem in that the accuracy of the method is decreased.

A third problem is that the discharge experience from full charge to full discharge of the battery 10 is required in order to detect the total usable capacity of the battery 10. However, a case where the battery 10 is discharged near the full discharge hardly exists in an actual use environment. Therefore, it is less likely that the total usable capacity of the battery 10 can be calculated. The three problems described above become main factors that contribute to an error in calculating the capacity of the battery 10.

Thus, the BMS 20 of some embodiments of the present invention calculates used capacity of the battery, uncharged capacity of the battery, maximum capacity of the battery, unusable capacity of the battery, actually usable capacity of the battery, remaining capacity of the battery, etc., in consideration of current discharge conditions, so that the capacity of a battery can be exactly calculated even under an environment in which the battery is partially charged/discharged.

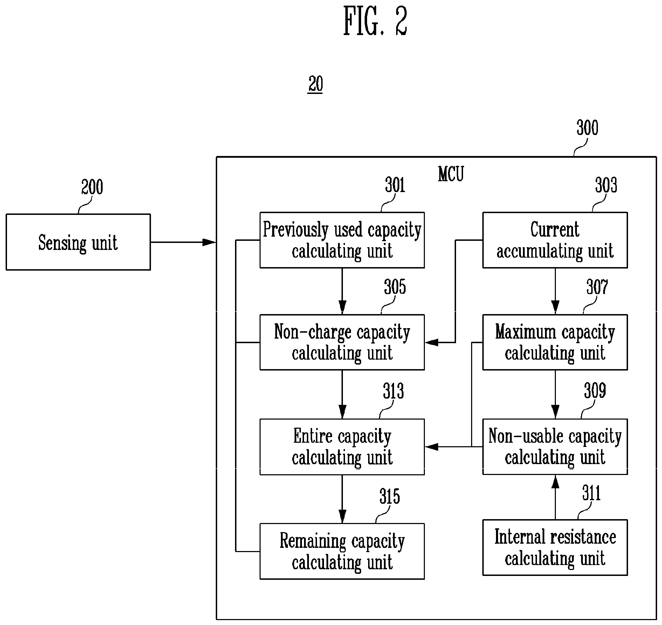

FIG. 2 is a block diagram schematically illustrating a BMS according to an embodiment.

As shown in FIG. 2, the BMS 20 includes a sensing unit 200 and a main controller unit (MCU) 300.

The sensing unit 200 obtains current value, voltage value and temperature value by measuring output current, voltage and temperature of a battery through a current sensor, a voltage sensor and a temperature sensor, respectively, and transmits the obtained data to the MCU 300.

According to an embodiment, the MCU 300 includes a used capacity calculating unit 301, a current integration unit 303, an uncharged capacity calculating unit 305, a maximum capacity calculating unit 307, a unusable capacity calculating unit 309, an internal resistance calculating unit 311, a total usable capacity calculating unit 313, and a remaining capacity calculating unit 315.

The used capacity calculating unit 301 calculates the used capacity of the battery, using an open circuit voltage (OCV) that is a voltage value obtained at the time when the battery is stabilized.

As used herein, the stabilized time of the battery refers to a discharge condition that satisfies at least one of a case where the magnitude of current discharged during a predetermined time is less than a predetermined value and a case where the change in voltage of the battery is less than a predetermined value.

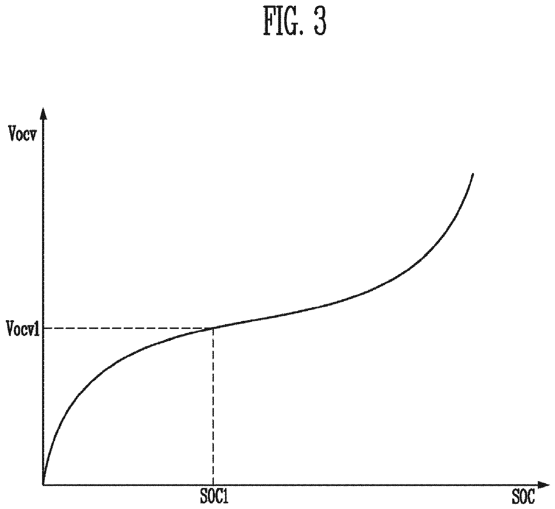

More specifically, the used capacity calculating unit 301 estimates a state of charge (SOC) from the OCV that is the voltage value at the time when the battery is stabilized and relational data between the OCV and the SOC. Specifically, the MCU 300 may previously store relation data experimentally obtained from the relationship between the OCV and the SOC. The relationship is shown in the graph of FIG. 3. As shown in FIG. 3, the used capacity calculating unit 301 detects an SOC (SOC1) corresponding to the OCV (Vocv1). Subsequently, the used capacity calculating unit 301 calculates the used capacity of the battery from the estimated SOC.

For example, when assuming that the maximum capacity of the battery is 1000mA/h and the estimated SOC of the battery is 40%, the used capacity of the battery may be calculated as 600mA/h that is 60% of the maximum capacity.

The current integration unit 303 calculates an integrated current value obtained by integrating the current value obtained in the sensing unit 200.

Here, the current value may include charge current having a positive (+) value and discharge current having a negative (-) value. Therefore, if the battery is charged and discharged with the same amount, the integrated current value becomes zero.

In embodiments disclosed herein, the calculation time of the used capacity of the battery becomes a reference time for integrating the measured current value. That is, the current integration unit 303 sets, as zero, the integrated current value at the calculation time of the used capacity, and calculates an integrated current value by integrating current value obtained thereafter.

The uncharged capacity calculating unit 305 calculates an uncharged capacity of the battery, using the used capacity of the battery, calculated in the used capacity calculating unit 301, and the integrated current value calculated in the current integration unit 303.

Generally, a battery is not charged up to the maximum capacity according to temperature and internal resistance. That is, although the battery may be considered to be fully charged, there occurs a capacity to which the battery is not charged. In embodiments of the present invention, the capacity is defined as an uncharged capacity.

Therefore, the integrated current value for calculating the uncharged capacity may be a first integrated current value obtained by accumulating current value until the full-charge time of the battery.

Here, the full-charge time may mean a time when the magnitude of the voltage value obtained in the sensing unit 200 is greater than or equal to a predetermined full-charge voltage value and when the magnitude of the current value obtained in the sensing unit 200 is less than a predetermined value. In this case, the full-charge voltage value is a value changeable depending on the capacity of the battery. The method of recognizing the full-charge time defined as described above is merely an embodiment, and it will be apparent to those skilled in the art that various changes and modifications may be made thereto without departing from the scope of the invention.

According to an embodiment, Equation 1 for calculating an uncharged capacity may be represented as follows.

## Equation 1

$$Q_{eoc} = Q_{start} - Q_{cc1}$$

Here, $Q_{eoc}$ denotes an uncharged capacity, $Q_{start}$ denotes a used capacity, and $Q_{cc1}$ denotes a first integrated current value.

For example, in a case where the used capacity is 600mA/h and the first integrated current value at the moment when the voltage value becomes the full-charge voltage value or more, the uncharged capacity may be 100mA/h.

The maximum capacity calculating unit 307 calculates the theoretical maximum capacity of the battery. More specifically, the maximum capacity calculating unit 307 may calculate the maximum capacity of the battery, using a first depth of discharge (DoD) calculated using a first OCV that is a voltage value obtained at a first stabilized time just before the last charge or discharge of the battery, a second DoD calculated using a second OCV that is a voltage value obtained at a second stabilized time after the last charge or discharge of the battery, and a second integrated current value obtained by accumulating current value from the calculation time of the used capacity to the second stabilized time.

Here, the stabilized time of the battery may mean a time to satisfy at least one of a case where the current of the battery is not discharged during a predetermined time and a case where the change in voltage of the battery is less than a predetermined value.

According to an embodiment, Equation 2 for calculating the maximum capacity may be represented as follows.

## Equation 2

$$Q_{ideal} = \frac{Q_{cc2}}{DoD_1 - DoD_2}$$

Here, $Q_{ideal}$ denotes the maximum capacity, $Q_{cc2}$ denotes the second integrated current value, $DoD_1$ denotes a first DoD, and $DoD_2$ denotes a second DoD.
In this case, the DoD may be represented by the following Equation 3.

## Equation 3

$$SOC[\%] = 100(1 - DoD)$$

Here, the DoD has a range of 0 to 1. That is, the DoD in the full-charge of the battery has a value of 0, and the DoD in the full-discharge of the battery has a value of 1.

Thus, the maximum capacity calculation unit 307 estimates an SOC, using the first OCV obtained at the first stabilized time, and estimates an SOC, using the second OCV obtained at the second stabilized time. The maximum capacity calculation unit 307 calculates the first DoD and the second DoD, using Equation 3.

According to an embodiment, the maximum capacity calculating unit 307 may calculate the maximum capacity when the second integrated current value is no less than a predetermined value. For example, the maximum capacity calculating unit 307 may calculate the maximum capacity when the second integrated current value is no less than 20% of the maximum capacity calculated before the second integrated current value. This is because, when the second integrated current value is too small, the error of the calculated maximum capacity may be large.

The unusable capacity calculating unit 309 calculates a unusable capacity under the current discharge condition of the battery, using current value and internal resistance of the battery.

Here, the unusable capacity means a remaining capacity that remains in the battery when the voltage value reaches a discharge stop voltage according to the discharge of the battery. That is, the minimum necessary voltage exists in order to drive a device using the battery. In a case where the output voltage of the battery drops to the minimum necessary voltage or less, the device cannot be operated. That is, the unusable capacity of the battery does not mean that the battery is completely discharged, but means a remaining capacity that remains in the battery when the voltage value of the battery drops to the minimum voltage for driving the device, i.e., the discharge stop voltage or less.

According to an embodiment, the unusable capacity calculating unit 309 may calculate the unusable capacity under the current discharge condition of the battery, further using discharge current previously stored in the MCU and a proportional coefficient between the internal resistance and unusable capacity of the battery.

In this case, the discharge condition may mean at least one of the magnitude of the current value in the discharge of the battery and the magnitude of the temperature value, and the unusable capacity may be represented by the following Equation 4.

## Equation 4

$$Q_{res} = \gamma I \left( R_o(T) - R_d \right)$$

Here, $Q_{res}$ denotes the unusable capacity, $\gamma$ denotes the proportional coefficient, I denotes current value in discharge, $R_o(T)$ denotes the internal resistance of the battery, and $R_d$ denotes a correction variable.

The correction variable means a value determined according to the magnitude of the current value in the discharge of the battery, and corrects an internal resistance value of the battery.

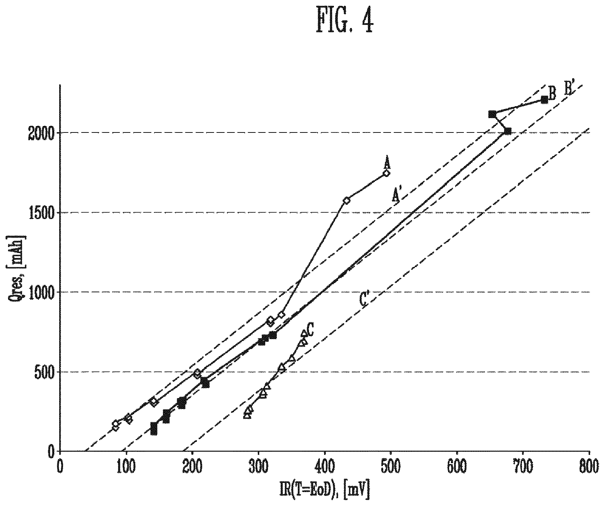

FIG. 4 is a graph illustrating the relationship among unusable capacity, current, temperature and internal resistance according to an embodiment of the present invention.

Referring to FIG. 4, graphs A, B and C are graphs according to Equation 4 when the magnitudes of discharge current of a battery are respectively a, b and c, and graphs A', B' and C' are graphs illustrating the relationship among unusable capacity, current, temperature and internal resistance, which are experimentally obtained when the sizes of discharge current of the battery are respectively a, b and c. Here, a, b and c have the relation of a<b<c.

In the graph of FIG. 4, the Y-axis denotes the unusable capacity ($Q_{res}$), the X-axis denotes the multiplication of current value and internal resistance, the slope of the graph denotes the proportional coefficient ($\gamma$), and the y-intercept denotes the relationship between the correction variable ($R_d$) and the current value. Therefore, the proportional coefficient ($\gamma$) and the correction variable ($R_d$) may be determined through the graphs A', B' and C' respectively obtained by approximating the experimentally obtained graphs A, B and C to primary expressions.

According to an embodiment, the internal resistance refers to a resistance value normalized according to the temperature of the battery, and the internal resistance calculating unit 311 may calculates an internal resistance of the battery, using the following Equation 5.

$$\text{Equation 5}$$

$$R_O(T) = R_a \alpha(T)$$

$$R_a = \frac{(Vocv - V)}{I\alpha(T)}$$

Here, $R_0(T)$ denotes an internal resistance, $R_a$ denotes a reference internal resistance, $\alpha(T)$ denotes a temperature correction variable, $V_{ocv}$ denotes an OCV voltage estimated using the SOC and the relation data between OCV and SOC, I denotes a current value in discharge, V denotes a voltage value in discharge.

More specifically, the reference internal resistance ($R_a$) refers to a value calculated using the OCV, current value, voltage value and temperature correction value, which are estimated using the SOC at an arbitrary point in the region where the DoD of the battery is 0 to 0.7. Preferably, the reference internal resistance ($R_a$)

may be a resistance value calculated in a state in which the DoD of the battery is 0.4.

The temperature correction variable is $\alpha(T)$ determined based on a relationship between the temperature value and the internal resistance.

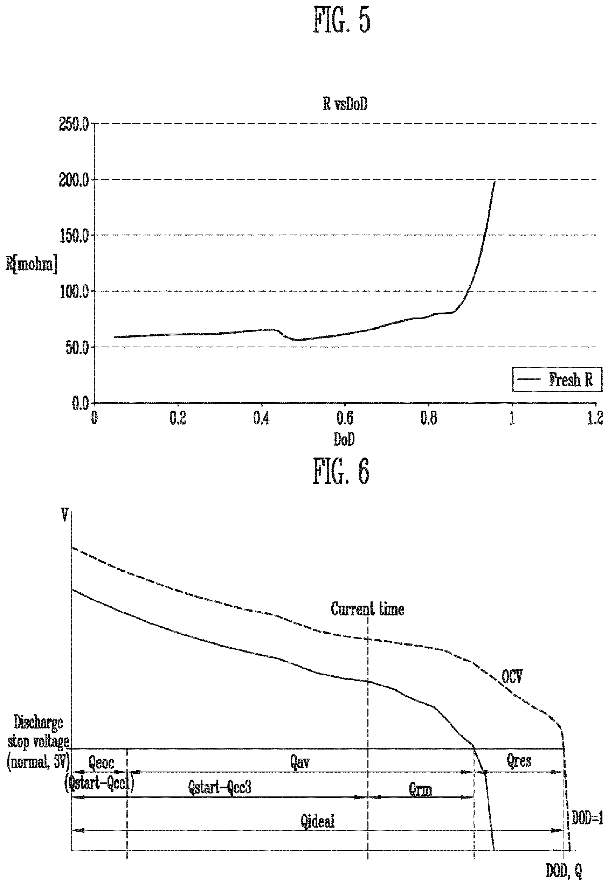

FIG. 5 is a graph illustrating the relationship between internal resistance and DoD of a battery according to an embodiment of the present invention.

Referring to FIG. 5, the internal resistance value in the region where the DoD of the battery is 0 to 0.7 is roughly flat, and in the range of 0 to 0.7 has a value smaller than the internal resistance value when the DoD of the battery exceeds 0.7. Thus, it is possible to decrease an error value of the unusable capacity calculated when the internal resistance value in the region where the DoD of the battery is 0 to 0.7, preferably when the DoD of the battery is 0.4, is used.

For example, when the DoD of the battery is 0.4, the SOC has a value of 60% according to Equation 3. The internal resistance calculating unit 311 calculates $V_{ocv}$, using the relation value between OCV and SOC shown in FIG. 3, and calculates the reference internal resistance ($R_a$), using the measured current value and voltage value. The internal resistance of the battery may have different internal resistance values according to the temperature of the battery under the same DoD condition. Thus, in order to standardize the internal resistance values, the internal resistance calculating unit 311 corrects the reference internal resistance ($R_a$), using the temperature correction variable ($\alpha(T)$) according to the temperature value when the DoD of the battery is 0.4. Here, the temperature correction variable ($\alpha(T)$) denotes the relation data between temperature and internal resistance for standardizing internal resistance values.

Subsequently, the internal resistance calculating unit 311 calculates internal resistance ($R_O(T)$) for calculating the unusable capacity ($Q_{res}$), using the reference internal resistance ($R_a$) and the temperature correction variable according to the temperature in the discharge of the battery.

The total usable capacity calculating unit 313 is configured to calculate a total usable capacity under the current discharge condition of the battery, using the uncharged capacity, the maximum capacity and the unusable capacity, which are calculated as described above. The total usable capacity of the battery may be represented by the following Equation 6.

$$\text{Equation 6}$$

$$Q_{av} = Q_{ideal} - Q_{eoc} - Q_{res}$$

Here, $Q_{av}$ denotes the total usable capacity, $Q_{ideal}$ denotes the maximum capacity, $Q_{eoc}$ denotes the uncharged capacity, and $Q_{res}$ denotes the unusable capacity.

The remaining capacity calculating unit 315 calculates a remaining capacity that remains under the current discharge condition, using the total usable capacity, the uncharged capacity, used capacity and a third integrated current value obtained by accumulating current value from the calculation time of the used capacity to the current time. The remaining capacity of the battery may be represented by the following Equation 7.

Equation 7

$$Q_{rm} = Q_{av} + Q_{eoc} - Q_{start} + Q_{cc3}$$

Here, $Q_{rm}$ denotes the remaining capacity of the battery, $Q_{av}$ denotes the total usable capacity, $Q_{eoc}$ denotes the uncharged capacity, $Q_{start}$ denotes the used capacity, and $Q_{cc3}$ denotes the third integrated current value.

FIG. 6 is a graph illustrating the relationship among maximum capacity, total usable capacity, uncharged capacity, used capacity, unusable capacity and remaining capacity of a battery according to an embodiment of the present invention.

Referring to FIG. 6, the BMS 20 of this embodiment of present invention calculates the uncharged capacity ($Q_{eoc}$), using the difference between the used capacity ($Q_{start}$) and the first integrated current value ($Q_{cc1}$), and calculates the total usable capacity ($Q_{av}$) usable according to the present discharge condition of the battery by calculating the present unusable capacity ($Q_{res}$). That is, in this embodiment of the present invention, the total usable capacity is newly calculated in consideration of the current discharge condition, so that it is possible to more precisely manage the capacity of the battery. The BMS 20 can exactly calculate the current remaining capacity ($Q_{rm}$), using the total usable capacity ($Q_{av}$) usable at the current time, the uncharged capacity ($Q_{eoc}$), the used capacity ($Q_{start}$) and the third integrated current value ($Q_{cc3}$).

In other words, the capacities (unusable capacity, total usable capacity, remaining capacity, etc.) according to the current discharge condition are newly calculated every time, the degradation characteristic changed depending on the use of the battery can be further reflected as compared with the related art method of calculating the capacity of the battery using the discharge efficiency table and the integrated current. Further, it is possible to precisely manage the capacities of the battery even in a partial charge/discharge environment.

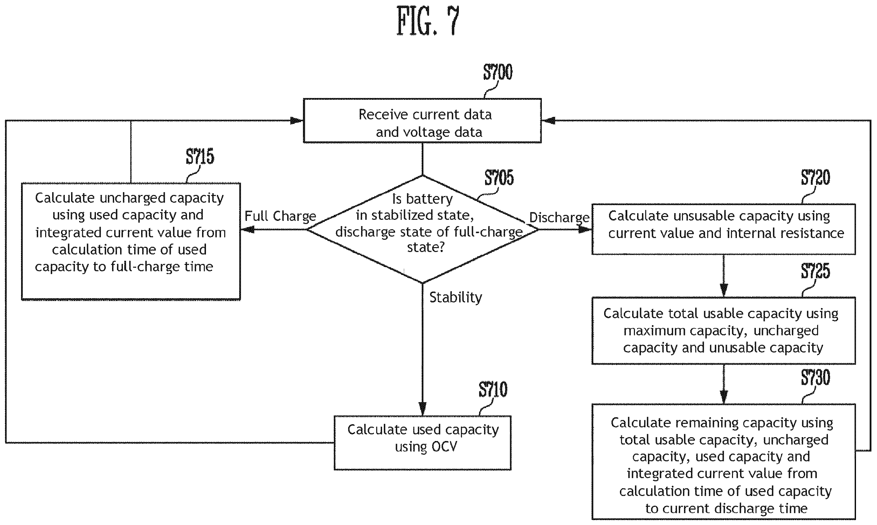

FIG. 7 is a flowchart illustrating a driving method of the BMS according to an embodiment of the present invention.

As shown in FIG. 7, the MCU 300 receives a current value and a voltage value of the battery, obtained from the sensing unit 200 (S700).

Subsequently, the MCU 300 decides whether the battery is in a stabilized state, discharge state or full-charge state, using the obtained current value and voltage value (S705).

In a case where the battery is in the stabilized state in step S705, the used capacity calculating unit 301 calculates a used capacity, using an OCV that is a voltage value measured at the stabilized time of the battery (S710).

In a case where the battery is in the full-charge state at step S705, the uncharged capacity calculating unit 305 calculates an uncharged capacity, using the calculated used capacity and an integrated current value obtained by accumulating current value from the calculation time of the used capacity to the full-charge time (S715).

In a case where the battery is in the discharge state in step S705, the unusable capacity calculating unit 309 calculates an unusable capacity, using the current value in the discharge of the battery and the internal resistance of the battery (S720). Subsequently, the total usable capacity calculating unit 313 calculates a total usable capacity of the battery, using the maximum capacity, uncharged capacity and unusable capacity of the battery (S725).

Finally, the remaining capacity calculating unit 315 calculates a remaining capacity of the battery, using the total usable capacity of the battery, the uncharged capacity, the used capacity and the integrated current value from the calculation time of the used capacity to the current discharge time (S730).

As discussed above, embodiments of the invention provide a battery management system, comprising: a sensing unit configured to measure a current value and a voltage value of a battery under a discharge condition of the battery; and a main controller unit, MCU, configured to receive the current and voltage values and further configured to manage capacities of the battery based at least in part on the current and voltage values, wherein the MCU includes an unusable capacity calculating unit configured to calculate an unusable capacity corresponding to a portion of a theoretical maximum capacity of the battery that is unusable under the discharge condition, wherein the unusable capacity is calculated based at least in part on the current value and an internal resistance value of the battery under the discharge condition.

In some embodiments, the unusable capacity includes a portion of the theoretical maximum capacity that remains in the battery when the magnitude of the voltage value has reached a discharge stop voltage corresponding to a minimum voltage that is sufficient to drive a device connected to the battery.

In some embodiments, the sensing unit is further configured to measure a temperature value of the battery under the discharge condition. In some such embodiments, the battery management system is further configured to calculate the internal resistance based on a reference internal resistance, and a temperature correction value. In some such embodiments, the reference internal resistance is calculated based at least on one of an open circuit voltage, OCV, value estimated using a state of charge, SOC, value, a current value, a voltage value, and the temperature correction value, and the temperature correction variable is determined based on a relationship between the temperature value and the internal resistance.

In some embodiments, the unusable capacity calculating unit is configured to calculate the unusable capacity further based on the current value, a proportionality coefficient and the internal resistance. In some such embodiments, the unusable capacity calculating unit is further configured to make a correcting adjustment to the internal resistance of the battery based on a correction variable determined according to the magnitude of the current value. In some such embodiments, the unusable capacity is calculated by multiplying the proportionality coefficient by the current value and by a value obtained by subtracting the correction variable from the internal resistance of the battery.

In some embodiments, the MCU further includes a total usable capacity calculating unit configured to calculate a total usable capacity of the battery at least in part based on the theoretical maximum capacity of the battery, an uncharged capacity of the battery, and the unusable capacity. In some such embodiments, this is done by subtracting the uncharged capacity and the unusable capacity from the theoretical maximum capacity.

In some embodiments, the MCU further includes a used capacity calculating unit configured to calculate a used capacity of the battery at least in part based on an open circuit voltage (OCV) value measured at a time when the battery has been stabilized.

In some embodiments, the MCU further includes an uncharged capacity calculating unit configured to calculate the uncharged capacity based at least in part on the used capacity and a first integrated current value obtained by integrating the current value from the calculation time of the used capacity to a full-charge time of the battery. In some such embodiments, this is done by subtracting the first integrated current from the used capacity.

In some embodiments, the MCU further includes a remaining capacity calculating unit configured to calculate a remaining capacity that is available for use, using the total usable capacity, the uncharged capacity, the used capacity and a third integrated current value obtained by integrating the current value from the calculation time of the used capacity to a time when the remaining capacity is calculated. In some such embodiments, this is done by adding the total usable capacity and the uncharged capacity, subtracting the used capacity and adding the third integrated current value. In other such embodiments, this is done by adding the third integrated current value to the maximum capacity and subtracting the unusable capacity and the used capacity.

As discussed above, embodiments of the invention can also provide a battery management system, comprising: a sensing unit configured to measure a current value and a voltage value of a battery under a discharge condition of the battery; and a main controller unit, MCU, configured to receive the current and voltage values and further configured to manage capacities of the battery based at least in part on the current and voltage values, wherein the MCU includes: a used capacity calculating unit configured to calculate a used capacity of the battery, at least in part based on an open circuit voltage, OCV, value obtained at a time when the battery has been stabilized; and an uncharged capacity calculating unit configured to calculate an uncharged capacity of the battery, at least in part based on the used capacity and an integrated current value obtained by integrating the current value from a calculation time of the used capacity to a full-charge time of the battery.

As discussed above, embodiments of the invention can also provide a driving method of a battery management system, comprising: receiving a current value and a voltage value of a battery under a discharge condition of the battery; calculating a used capacity of the battery, at least in part based on an open circuit voltage, (OCV,) value obtained at a time when the battery has been stabilized; and calculating an uncharged capacity of the battery, based at least in part on a used capacity and an integrated current value obtained by integrating the current value from a calculation time of the used capacity to a full-charge time of the battery. In some such embodiments, the uncharged capacity is calculated by subtracting the integrated current value from the used capacity.

In some embodiments, the method can further comprise calculating an unusable capacity including a portion of a theoretical maximum capacity that is unusable under the discharge condition of the battery, based at least in part on the current value and an internal resistance value of the battery.

In some embodiments, the method can further comprise calculating a total usable capacity of the battery, based at least in part on a maximum capacity of the battery, the uncharged capacity of the battery and the unusable capacity. In some such embodiments, this is done by subtracting the uncharged capacity and the unusable capacity from the theoretical maximum capacity.

In some embodiments, the method can further comprise calculating a remaining capacity that is available for use, based at least in part on the total usable capacity, the uncharged capacity, the used capacity, and an integrated current value obtained by integrating the current value from a calculation time of the used capacity to the time when the remaining capacity is calculated. In some such embodiments, this is done by adding the total usable capacity and the uncharged capacity, subtracting the used capacity and adding the third integrated current value. In other such embodiments, this is done by adding the third integrated current value to the maximum capacity and subtracting the unusable capacity and the used capacity.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

**Claims**

1. A battery management system (20), comprising:

   a sensing unit (200) configured to measure a current value and a voltage value of a battery; and
   a main controller unit, MCU, (300) configured to receive the current and voltage values and further configured to manage capacities of the battery based at least in part on the current and voltage values,
   wherein the MCU includes:

   a used capacity calculating unit (301) configured to calculate a used capacity of the battery, at least in part based on an open circuit voltage, OCV, value obtained at a time when the battery has been stabilized;

   **characterized by** an uncharged capacity calculating unit (305) configured when the battery is fully charged to calculate an uncharged capacity of the battery, at least in part based on the used capacity and an integrated current value obtained by integrating the current value from a calculation time of the used capacity to a full-charge time of the battery, wherein the uncharged capacity of the battery is a potentially usable capacity of the battery that cannot be used at a particular temperature and internal resistance value of the battery.

2. A driving method of a battery management system, comprising:

   receiving a current value and a voltage value of a battery;
   calculating a used capacity of the battery, at least in part based on an open circuit voltage, OCV, value obtained at a time when the battery has been stabilized;

**characterized by** calculating an uncharged capacity of the battery when the battery is fully charged, based at least in part on a used capacity and an integrated current value obtained by integrating the current value from a calculation time of the used capacity to a full-charge time of the battery, wherein the uncharged capacity of the battery is a potentially usable capacity of the battery that cannot be used at a particular temperature and internal resistance value of the battery.

3. The driving method of claim 2, further comprising calculating an unusable capacity including a portion of a theoretical maximum capacity that is unusable under the discharge condition of the battery, based at least in part on the current value and an internal resistance value of the battery.

4. The driving method of claim 3, further comprising calculating a total usable capacity of the battery, based at least in part on a maximum capacity of the battery, the uncharged capacity of the battery and the unusable capacity

5. The driving method of claim 4, further comprising calculating a remaining capacity that is available for use, based at least in part on the total usable capacity, the uncharged capacity, the used capacity, and an integrated current value obtained by integrating the current value from a calculation time of the used capacity to the time when the remaining capacity is calculated.

**Patentansprüche**

1. Batterieverwaltungssystem (20), umfassend:

   eine Abfühleinheit (200), die so konfiguriert ist, dass sie einen Stromwert und einen Spannungswert einer Batterie misst; und
   ein zentrales Leitwerk, MCU, (300), das so konfiguriert ist, dass es die Strom- und Spannungswerte empfängt, und ferner so konfiguriert ist, dass es Kapazitäten der Batterie zumindest teilweise auf der Grundlage der Strom- und Spannungswerte verwaltet,
   wobei das MCU Folgendes enthält:

   eine Einheit (301) zur Berechnung einer genutzten Kapazität, die so konfiguriert ist, dass sie eine genutzte Kapazität der Batterie berechnet, zumindest teilweise auf der Grundlage eines Leerlaufspannungswertes, OCV-Wertes, erlangt zu einem Zeitpunkt, zu dem die Batterie stabilisiert worden ist;

**gekennzeichnet durch**

eine Einheit (305) zur Berechnung einer ungeladenen Kapazität, die so konfiguriert ist, wenn die Batterie vollgeladen ist, dass sie eine ungeladene Kapazität der Batterie berechnet, zumindest teilweise auf der Grundlage der genutzten Kapazität und eines integrierten Stromwertes, erlangt durch Integrieren des Stromwertes von einer Rechenzeit der genutzten Kapazität bis zu einer Vollladungszeit der Batterie, wobei die ungeladene Kapazität der Batterie eine potenziell nutzbare Kapazität der Batterie ist, die bei einem bestimmten Temperatur- und Innenwiderstandswert der Batterie nicht genutzt werden kann.

**2.** Antriebsverfahren eines Batterieverwaltungssystems, umfassend:

Empfangen eines Stromwertes und eines Spannungswertes einer Batterie;

Berechnen einer genutzten Kapazität der Batterie, zumindest teilweise auf der Grundlage eines Leerlaufspannungswertes, OCV-Wertes, erlangt zu einem Zeitpunkt, zu dem die Batterie stabilisiert worden ist;

**gekennzeichnet durch**

Berechnen einer ungeladenen Kapazität der Batterie, wenn die Batterie vollgeladen ist, zumindest teilweise auf der Grundlage einer genutzten Kapazität und eines integrierten Stromwertes, erlangt durch Integrieren des Stromwertes von einer Rechenzeit der genutzten Kapazität bis zu einer Vollladungszeit der Batterie, wobei die ungeladene Kapazität der Batterie eine potenziell nutzbare Kapazität der Batterie ist, die bei einem bestimmten Temperatur- und Innenwiderstandswert der Batterie nicht genutzt werden kann.

**3.** Antriebsverfahren nach Anspruch 2, ferner umfassend das Berechnen einer nicht nutzbaren Kapazität, die einen Teil einer theoretischen Maximalkapazität enthält, der unter der Entladebedingung der Batterie nicht nutzbar ist, zumindest teilweise auf der Grundlage des Stromwertes und eines Innenwiderstandswertes der Batterie.

**4.** Antriebsverfahren nach Anspruch 3, ferner umfassend das Berechnen einer gesamten nutzbaren Kapazität der Batterie zumindest teilweise auf der Grundlage einer Maximalkapazität der Batterie, der ungeladenen Kapazität der Batterie und der nicht nutzbaren Kapazität.

**5.** Antriebsverfahren nach Anspruch 4, ferner umfassend das Berechnen einer Restkapazität, die für die Nutzung zur Verfügung steht, zumindest teilweise auf der Grundlage der gesamten nutzbaren Kapazität, der ungeladenen Kapazität, der genutzten Kapazität und eines integrierten Stromwertes, erlangt durch Integrieren des Stromwertes von einer Rechenzeit der genutzten Kapazität bis zu dem Zeitpunkt, zu dem die Restkapazität berechnet wird.

## Revendications

**1.** Système de gestion de batterie (20), comprenant :

une unité de détection (200) configurée pour mesurer une valeur de courant et une valeur de tension d'une batterie ; et

une unité de commande principale, MCU, (300), configurée pour recevoir les valeurs de courant et de tension, et configurée de plus pour gérer des capacités de la batterie, en fonction, au moins en partie, des valeurs de courant et de tension,

dans lequel la MCU comprend :

une unité de calcul de capacité utilisée (301) configurée pour calculer une capacité utilisée de la batterie, en fonction, au moins en partie, d'une valeur de tension de circuit ouvert, OCV, obtenue à un temps où la batterie a été stabilisée ;

**caractérisé par** :

une unité de calcul de capacité non chargée (305) configurée, lorsque la batterie est complètement chargée, pour calculer une capacité non chargée de la batterie, en fonction, au moins en partie, de la capacité utilisée et d'une valeur de courant intégrée obtenue par l'intégration de la valeur de courant à partir d'un temps de calcul de la capacité jusqu'à un temps de pleine charge de la batterie, la capacité non chargée de la batterie étant une capacité potentiellement utilisable de la batterie qui ne peut pas être utilisée à une température et à une valeur de résistance interne particulières de la batterie.

**2.** Procédé d'attaque d'un système de gestion de batterie, comprenant :

la réception d'une valeur de courant et d'une valeur de tension d'une batterie ;

le calcul d'une capacité utilisée de la batterie, en fonction, au moins en partie, d'une valeur de tension de circuit ouvert, OCV, obtenue à un temps où la batterie a été stabilisée ;

**caractérisé par** :

le calcul d'une capacité non chargée de la batterie lorsque la batterie est complètement chargée, en fonction, au moins en partie, d'une capacité utilisée et d'une valeur de courant intégrée obtenue par l'intégration de la valeur de courant à partir d'un temps de calcul de la capacité utilisée jusqu'à un temps de pleine charge de la batterie, la capacité non chargée de la batterie étant une capacité potentiellement utilisable de la batterie qui ne peut pas être utilisée à une température et à une valeur de résistance interne particulières de la batterie.

3. Procédé d'attaque selon la revendication 2, comprenant de plus le calcul d'une capacité inutilisable comprenant une partie d'une capacité maximale théorique qui est inutilisable dans la condition de décharge de la batterie, en fonction, au moins en partie, de la valeur de courant et d'une valeur de résistance interne de la batterie.

4. Procédé d'attaque selon la revendication 3, comprenant de plus le calcul d'une capacité utilisable totale de la batterie, en fonction, au moins en partie, d'une capacité maximale de la batterie, de la capacité non chargée de la batterie et de la capacité inutilisable.

5. Procédé d'attaque selon la revendication 4, comprenant de plus le calcul d'une capacité restante qui est disponible pour l'utilisation, en fonction, au moins en partie, de la capacité utilisable totale, de la capacité non chargée, de la capacité utilisée, et d'une valeur de courant intégrée obtenue par l'intégration de la valeur de courant à partir d'un temps de calcul de la capacité utilisée jusqu'au temps où la capacité restante est calculée.

# FIG. 1

# FIG. 2

<u>20</u>

300

| | MCU |
|---|---|
| 200 | |

Sensing unit

301
Previously used capacity calculating unit

303
Current accumulating unit

305
Non-charge capacity calculating unit

307
Maximum capacity calculating unit

313
Entire capacity calculating unit

309
Non-usable capacity calculating unit

315
Remaining capacity calculating unit

311
Internal resistance calculating unit

# FIG. 3

FIG. 4

# FIG. 5

# FIG. 6

# FIG. 7

S700

Receive current data
and voltage data

S715

Calculate uncharged capacity
using used capacity and
integrated current value from
calculation time of used
capacity to full-charge time

S705

Full Charge ← Is battery
in stabilized state,
discharge state of full-charge
state? → Discharge

Stability

S720

Calculate unsusable capacity using
current value and internal resistance

S725

Calculate total usable capacity using
maximum capacity, uncharged
capacity and unusable capacity

S730

Calculate remaining capacity using
total usable capacity, uncharged
capacity, used capacity and
integrated current value from
calculation time of used capacity
to current discharge time

S710

Calculate used capacity
using OCV

EP 2 952 922 B1

**EP 2 952 922 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2071345 A